# EUROPÄISCHE PATENTSCHRIFT

(11) **EP 1 497 484 B1**
(45) Veröffentlichungstag und Bekanntmachung des Hinweises auf die Patenterteilung: **03.01.2007**
(21) Anmeldenummer: 03722390.6
(22) Anmeldetag: 03.04.2003
(51) Int. Cl.: C30B 15/10, C03B 19/09

(54) **QUARZGLASTIEGEL UND VERFAHREN ZUR HERSTELLUNG DESSELBEN**
QUARTZ GLASS CRUCIBLE AND METHOD FOR THE PRODUCTION THEREOF
CREUSET EN VERRE DE QUARTZ ET PROCEDE PERMETTANT DE LE PRODUIRE

(30) Priorität: 22.04.2002 DE 10217946
(43) Veröffentlichungstag der Anmeldung: 19.01.2005
(73) Patentinhaber: Siltronic AG, 81737 München (DE); Wacker Siltronic AG, 84489 Burghausen (DE)
(72) Erfinder: KORUS, Gabriele, 04109 Leipzig (DE); ARNDT, Martin, 06749 Bitterfeld (DE); LAUDAHN, Hilmar, 06749 Bitterfeld (DE); SCHWARZBAUER, Manfred, 84359 Simbach (DE)
(86) Internationale Anmeldenummer: PCT/EP2003/003459
(87) Internationale Veröffentlichungsnummer: WO 2003/089693

(56) Entgegenhaltungen:
- EP-A- 0 748 885
- EP-A- 0 911 429
- WO-A-00/46432
- WO-A-02/16677
- US-A- 5 389 582
- US-A- 5 968 259

## Beschreibung

Die Erfindung betrifft einen Quarzglastiegel zum Kristallziehen mit einer Tiegelwandung, umfassend eine Außenschicht aus opakem Quarzglas und eine Innenschicht, wobei die Außenschicht einen inneren Bereich und einen äußeren Bereich aufweist, der mit einem Kristallisationspromotor versehen ist, der beim Aufheizen des Quarzglastiegels beim bestimmungsgemäßen Einsatz beim Kristallziehen eine Kristallisation von Quarzglas unter Bildung von Cristobalit bewirkt.

Weiterhin betrifft die Erfindung ein Verfahren zur Herstellung eines Quarzglastiegels, indem ein eine Außenschicht aus opakem Quarzglas und eine Innenschicht aufweisender Tiegelbasiskörper hergestellt wird, wobei die Außenschicht in einem einen inneren Bereich umgebenden äußeren Bereich mindestens teilweise mit einem Kristallisationspromotor versehen wird, der beim Aufheizen des Quarzglastiegels beim bestimmungsgemäßen Einsatz beim Kristallziehen eine Kristallisation von Quarzglas unter Bildung von Cristobalit bewirkt.

Quarzglastiegel werden beispielsweise zur Aufnahme der Metallschmelze beim Ziehen von Einkristallen nach dem sogenannten Czochralski-Verfahren eingesetzt. Bei diesem Verfahren wird ein Impfkristall mit vorgegebener Orientierung in die Schmelze eingetaucht und dann langsam hochgezogen. Impfkristall und Schmelze rotieren dabei gegenläufig. Die Oberflächenspannung zwischen Impfkristall und Schmelze bewirkt, dass mit dem Impfkristall auch Schmelze abgezogen wird, die allmählich erkaltet und dadurch zu einem stetig weiterwachsenden Einkristall erstarrt. Bei diesem Ziehprozess unterliegt der Quarzglastiegel über mehrere Stunden hohen mechanischen, chemischen und thermischen Belastungen, denen er ohne merkliche plastische Verformungen standhalten muss. Je größer der Tiegel und damit das darin aufzunehmende Schmelzvolumen ist, desto länger dauern in der Regel die Schmelzzeiten.

Um die thermische Stabilität des Quarzglastiegels zu erhöhen wird in der EP-A 748 885 vorgeschlagen, diesen mit einer Oberflächenschicht aus Cristobalit zu versehen. Der Schmelzpunkt von Cristobalit liegt mit etwa 1720°C deutlich oberhalb der Schmelztemperaturen üblicher Halbleitermaterialien (im Fall einer Siliciumschmelze beträgt die Schmelztemperatur beispielsweise ca. 1420°C). Zur Erzeugung der Cristobalit-Oberflächenschicht wird die glasige Außenwandung eines handelsüblichen Tiegels aus opakem, blasenhaltigem Quarzglas mit einer chemischen Lösung behandelt, die Substanzen enthält, die eine Entglasung von Quarzglas zu Cristobalit fördern ("Kristallisationspromotor"). Als Kristallisationspromotoren werden im Wesentlichen Bor-, Erdalkali- und Phosphorverbindungen empfohlen; bevorzugt wird Bariumhydroxid eingesetzt. Beim Aufheizen des Quarzglastiegels auf eine Temperatur oberhalb von 1420 °C - zum Beispiel während des Einsatzes beim Kristallziehprozess - kristallisiert die vorbehandelte Tiegelwandung oberflächlich unter Bildung von Cristobalit aus, was zu einer höheren mechanischen und thermischen Festigkeit des Quarzglastiegels beiträgt.

Das Aufbringen des Kristallisationspromotors zur Erzeugung der kristallisierten Außenschicht erfordert einen zusätzlichen Verfahrensschritt am Ende des Prozesses, der zu hohen Kosten bei Ausschuß aufgrund eines Fehlers führt, und ist nur mit großem Aufwand reproduzierbar. Beispielsweise ist Bariumhydroxid an Luft sehr reaktiv; es neigt zur Reaktion mit dem Kohlendioxid der Luft unter Bildung von Bariumcarbonat. Eine exakte Einwaage dieser Substanz wird dadurch erschwert. Zudem ist die gleichmäßige Verteilung des Kristallisationspromotors auf der Tiegeloberfläche und somit das Kristallwachstum kaum kontrollierbar. Beim Transport oder vor dem Einsatz des Quarzglastiegels kann der Kristallisationspromotor abgerieben werden. Ob die Kristallisation in der gewünschten Art und Weise eintritt, ist daher in der Regel nicht vorhersehbar und erweist sich erst während des Einsatzes des Quarzglastiegels. Darüber hinaus zeigt Barium eine nur geringe Beweglichkeit in Quarzglas, so dass die Stärke der kristallisierten Oberflächenschicht bei dem bekannten Quarzglastiegel gering ist; sie liegt in der Regel bei etwa 50 µm. Eine derartig dünne Schicht kann leicht abblättern und beim Einsatz verletzt werden. Aus diesem Grund ist der bekannte Quarzglastiegel zur Aufnahme eines großen Schmelzvolumens und den damit einhergehenden langen Prozessdauern nicht geeignet.

Der Erfindung liegt die Aufgabe zugrunde, einen Quarzglastiegel mit langer Standzeit bereitzustellen und ein kostengünstiges Verfahren zur reproduzierbaren Herstellung eines derartigen Quarzglastiegels anzugeben, das eine hohe Ausbeute hinsichtlich des Tiegels und der darin zu erschmelzenden Halbleitermaterialien ermöglicht.

Im Hinblick auf den Tiegel wird diese Aufgabe ausgehend von einem Quarzglastiegel der eingangs genannten Gattung erfindungsgemäß dadurch gelöst, dass der Kristallisationspromotor eine in Quarzglas - zusätzlich zu Silicium - als Netzwerkbildner wirkende und/oder eine in Quarzglas als Netzwerkwandler wirkende erste Komponente und eine in Quarzglas als Trennstellenbildner wirkende, alkalimetallfreie zweite Komponente enthält, und dass die besagten Komponenten in einem eine Schichtdicke von mehr als 0,2 mm aufweisenden Dotierungsbereich der Außenschicht enthalten und darin eingeschlossen sind.

Bei einem Einsatz zum Ziehen von Halbleiterkristallen wird der Quarzglastiegel auf eine Temperatur oberhalb der Schmelztemperatur des jeweiligen Halbleitermaterials erhitzt (bei Silicium ca. 1425 °C). Ein wesentlicher Aspekt der Erfindung besteht darin, dass der Quarzglastiegel eine Außenschicht aufweist, in der (in einem Dotierungsbereich) ein Kristallisationspromotor eingeschlossen ist, und von dem ausgehend während des Einsatzes des Tiegels eine Kristallisation im Bereich der Außenoberfläche des Quarzglastiegels hervorgerufen wird. Hierzu ist der Kristallisationspromotor im Dotierungsbereich in einer Art und Menge enthalten, die geeignet ist, bei den hohen Temperaturen des Kristallziehprozesses, zum Beispiel beim Aufschmelzen des Siliciums im Quarzglastiegel (oberhalb von 1400 °C) die Kristallisation von Quarzglas zu Cristobalit zu bewirken.

Eine Kristallisation während der Herstellung des Quarzglastiegels wird vermieden. Denn wegen der Unterschiede der thermischen Ausdehnungskoeffizienten von Quarzglas und Cristobalit sowie der Phasenumwandlung von β- Cristobalit in α-Cristobalit bei 275°C würde ein kristallisierter Bereich beim Abkühlen mechanische Spannungen induzieren, die zu Rissen oder gar zum Bruch des Tiegels führen können. Im Idealfall zeigt der Quarzglastiegel nach seiner Herstellung keine Kristallisation, sondern allenfalls mikroskopisch kleine Kristallisationskeime im Dotierungsbereich, die unter dem Lichtmikroskop nicht erkennbar sind. Erst die Temperaturerhöhung beim bestimmungsgemäßen Einsatz des Quarzglastiegels führt zur Kristallisation, die dabei im Wesentlichen im Dotierungsbereich der Außenschicht erfolgt. Diese Kristallisation verbessert die mechanische und thermische Stabilität des Quarzglastiegels und verlängert dessen Standzeit.

Der erfindungsgemäße Quarzglastiegel unterscheidet sich von dem bekannten Quarzglastiegel im mehrerer Hinsicht:
- Der Kristallisationspromotor ist im Dotierungsbereich der Außenschicht eingeschlossen. Die Konzentration und Verteilung des Kristallisationspromotors in der Außenschicht wird beim Herstellungsprozess festgelegt. Eine Gefahr einer unbeabsichtigten Veränderung der Konzentration oder Verteilung, etwa beim Transport oder beim Einfüllen der Schmelze, besteht nicht. Die Verteilung und Konzentration ist daher reproduzierbar und bis zum bestimmungsgemäßen Einsatz des Tiegels eindeutig und unabänderlich.
- Ein weiterer wesentlicher Unterschied zu dem bekannten Quarzglastiegel besteht darin, dass der Kristallisationspromotor mindestens zwei Komponenten umfasst, nämlich mindestens eine erste Komponente, die in Quarzglas als Netzwerkbildner oder als Netzwerkwandler wirkt und mindestens eine in Quarzglas als Trennstellenbildner wirkende, alkalimetallfreie zweite Komponente.

Die als Trennstellenbildner wirkende zweite Komponente wird im Folgenden auch kurz als "Trennstellenbildner" bezeichnet. Als "Trennstellenbildner" gelten Ionen, die das Quarzglas-Netzwerk abbauen.

Die in Quarzglas als Netzwerkbildner und/oder als Netzwerkwandler wirkende erste Komponente wird im Folgenden kurz als "Netzwerkbildner" bezeichnet, sofern nicht ausdrücklich zwischen "Netzwerkbildner im klassischen Sinn" und Netzwerkwandler unterschieden wird. Als "Netzwerkbildner" im klassischen Sinn werden diejenigen Ionen bezeichnet, deren Oxide durch Polyederbildung ein Glasnetzwerk aufbauen, während unter einem "Netzwerkwandler" Ionen verstanden werden, die zwar das Quarzglas-Netzwerk verändern oder "wandeln", jedoch keine Netzwerk-Trennstellen bilden. Als "Netzwerkbildner" im klassischen Sinn gelten für Quarzglas im Allgemeinen die Oxide folgender Komponenten: Titan, Zirkonium, Hafnium, Germanium und Zinn. Als "Netzwerkwandler" werden zum Beispiel Bor, Aluminium, Gallium, Phosphor, Arsen, Antimon, Vanadium, Niob und Tantal angesehen.

Die als Trennstellenbildner wirkende zweite Komponente trägt im Wesentlichen zur Kristallisation des Quarzglases bei. Erfindungsgemäß handelt es sich dabei um eine alkalimetallfreie Komponente, so dass die Gefahr einer Verunreinigung der im Quarzglastiegel enthaltenden Schmelze durch Alkalimetalllonen verringert wird. Als alkalimetallfreie Trennstellenbildner kommen beispielsweise folgende Komponenten in Frage: Magnesium, Calcium, Strontium und Barium.

Die kristallisierende Wirkung des "Trennstellenbildners" wird unterstützt durch den zusätzlichen "Netzwerkbildner". Diese unterstützende Wirkung des "Netzwerkbildners" kann auf seinen Einfluss auf die Stabilität der Glasstruktur zurückgeführt werden. Sie führt dazu, dass die Kristallisation im Dotierungsbereich bereits bei einer geringeren Konzentration des "Trennstellenbildners" einsetzt, als dies ohne die gleichzeitige Anwesenheit des "Netzwerkbildners" der Fall wäre. Eine niedrige Konzentration des "Trennstellenbildners" hat mehrere Vorteile:
- Bereits geringe Mengen an "Trennstellenbildner" verringern die Viskosität von Quarzglas. Für den Einsatz als Quarzglastiegel ist eine niedrige Viskosität nachteilig. Dadurch, dass beim erfindungsgemäßen Quarzglastiegel die zur Kristallisation erforderliche Konzentration an "Trennstellenbildner" niedrig gehalten werden kann, ist sein viskositätserniedrigender Einfluss geringer.
- Selbst bei kleinen Verteilungskoeffizienten des "Trennstellenbildners" in Silicium wird doch stets ein Anteil in den Einkristall eingebaut und dadurch die elektronischen Eigenschaften des Halbleitermaterials beeinträchtigt. Auch deswegen ist es günstig, die Konzentration an "Trennstellenbildner" so gering wie möglich zu halten und nur so hoch wie nötig einzustellen, um die gewünschte Kristallisation des Quarzglases herbeizuführen.
- Auch ein "Netzwerkbildner" kann eine Kristallisation in Quarzglas bewirken, jedoch nur in hoher Konzentration. Eine hohe Konzentration an "Netzwerkbildner" würde sich jedoch auf die chemischen und mechanischen Eigenschaften des Tiegels ungünstig auswirken und die Belastung des Halbleitermaterials mit Fremdsubstanzen vergrößern. Im erfindungsgemäßen Quarzglastiegel ist eine derartig hohe Konzentration im Dotierungsbereich jedoch nicht erforderlich, da der "Netzwerkbildner" in Kombination mit einem "Trennstellenbildner" eingesetzt wird, der die Kristallisation erleichtert. Kleinere Mengen an "Trennstellenbildner" und "Netzwerkbildner" sind zudem kostengünstiger und umweltverträglicher.
   Der Kristallisationspromotor - umfassend eine Kombination eines "Netzwerkbildners" und eines "Trennstellenbildners" - gewährleistet somit eine die mechanische Stabilität des Quarzglastiegels unterstützende Kristallisation im Dotierungsbereich, ohne dass hierfür hohe Konzentrationen an "Netzwerkbildner" und an "Trennstellenbildner" erforderlich sind. Dadurch wird im Vergleich zu dem bekannten Tiegel die Gefahr verringert, dass Fremdsubstanz in die Halbleiterschmelze gelangt, so dass eine höhere Ausbeute an geeignetem Halbleitermaterial erreichbar ist.

Der Kristallisationspromotor ist in einem Dotierungsbereich der Außenschicht enthalten und darin eingeschlossen. Der Dotierungsbereich umfasst die gesamte Außenschicht des Tiegels oder einen Teil davon. Er weist eine Schichtdicke von mindestens 0,2 mm auf, so dass die sich daraus entwickelnde kristallisierte Schicht eine dementsprechende Mindeststärke hat, was die Gefahr eines Abplatzens oder einer Beschädigung der Schicht beim bestimmungsgemäßen Einsatz des Quarzglastiegels vermindert.

Der erfindungsgemäße Quarzglastiegel ist mit einer transparenten Innenschicht aus Quarzglas versehen, das aus natürlich vorkommenden Rohstoffen (Quarz) oder aus synthetisch erzeugtem SiO₂ hergestellt ist. Um eine Beeinträchtigung der innenschicht durch die Kristallisation im Dotierungsbereich zu vermeiden, ist zwischen Innenschicht und Dotierungsbereich eine räumliche Trennung vorgesehen, die mindestens den inneren Bereich der Außenschicht umfasst.

Als besonders günstig hat es sich erwiesen, wenn die als Netzwerkbildner wirkende erste Komponente eine vierwertige Substanz enthält.

Hierbei handelt es sich um Komponenten, die dieselbe Wertigkeit wie Silicium (Si⁴⁺) in der Verbindung SiO₂ aufweisen. Es wird dadurch gewährleistet, dass der "Netzwerkbildner" keinen Einfluss auf die elektronischen Verhältnisse im Einkristall ausübt, sollte er in die Schmelze gelangen, da er im Siliciumeinkristall weder p- noch n-dotierend wirkt. Es handelt sich hierbei um "Netzwerkbildner" im klassischen Sinne. Andere als derartige vierwertige "Netzwerkbildner", also die oben als "Netzwerkwandler" bezeichneten Elemente, bei denen es sich um drei- oder fünfwertige Substanzen handelt, führen zum Ausgleich der elektronischen Wertigkeit gegenüber Si⁴⁺ leicht zu einem Einschleppen von insbesondere Alkalimetallionen-Verunreinigungen im Quarzglas. Dieser "Gettereffekt" wird beim Einsatz von vierwertigen "Netzwerkbildnern" vermieden.

Vorzugsweise ist die vierwertige Substanz Zirkonium (Zr⁴⁺), Titan (Ti⁴⁺), Hafnium (Hf⁴⁺) und/oder Germanium (Ge⁴⁺).

Als besonders vorteilhaft hat sich eine als Trennstellenbildner wirkende zweite Komponente erweisen, die eine zweiwertige, alkalimetallfreie Substanz enthält. "Trennstellenbildner" führen bereits bei geringer Konzentration zu einer Cristobalitbildung. Die dafür notwendige Konzentration wird erfindungsgemäß weiter dadurch abgesenkt, dass zusätzlich zu dem "Trennstellenbildner" oder zu den "Trennstellenbildnern" eine oder mehrere "Netzwerkbildner" im Dotierungsbereich enthalten sind.

Vorzugsweise ist die zweiwertige, alkalimetallfreie Substanz Barium (Ba²⁺) und/oder Strontium (Sr²⁺). Insbesondere Barium zeichnet sich darüber hinaus durch eine geringe Beweglichkeit in Quarzglas aus, so dass die kristallisierte Zone leicht auf den Dotierungsbereich beschränkt und entsprechend der örtlichen Verteilung des "Trennstellenbildners" gestaltet werden kann.

Die erste und die zweite Komponente weisen vorteilhafterweise einen Verteilungskoeffizienten in Silicium von kleiner als 10⁻⁵ auf. Durch einen kleinen Verteilungskoeffizienten wird gewährleistet, dass möglichst wenig der Komponenten in den beim Ziehverfahren erzeugten Kristall eingebaut wird, und somit dessen elektronische Eigenschaften nicht beeinträchtigt werden.

Besonders bewährt hat sich eine Ausführungsform des erfindungsgemäßen Quarzglastiegels, bei dem die erste Komponente und die zweite Komponente jeweils in einer Konzentration im Bereich von 0,003 mol-% bis 0,02 mol-% im Dotierungsbereich enthalten sind. Die Konzentrationsangabe bezieht sich auf die Konzentration der genannten Komponenten im Quarzglas. Bei Konzentrationen unterhalb der genannten Untergrenze wird keine vollständige Kristallisation im Dotierungsbereich erreicht. Dabei ist zu beachten, dass Verunreinigungen in Quarzglas in der Regel die Cristobalitbildung fördern, so dass bei verunreinigtem Quarzglas eine vollständige Kristallisation auch bei einer Konzentration der Komponenten unterhalb der genannten Untergrenze zu erwarten ist. Der oben als bevorzugt angegebene Konzentrationsbereich gilt daher nur unter der Maßgabe, dass der Dotierungsbereich - abgesehen von dem zudotierten Kristallisationspromotor - aus reinem Quarzglas besteht. Die angegebene Obergrenze des bevorzugten Konzentrationsbereichs ergibt sich aus der Notwendigkeit, die Gehalte von Fremdsubstanzen im Rahmen des Kristallziehprozesses im Hinblick auf die erforderliche Reinheit des Halbleitermaterials und stabiler Schmelzbedingungen so gering wie möglich zu halten. Als besonders vorteilhaft haben sich Konzentrationen der ersten und der zweiten Komponente von jeweils etwa 0,006 mol-% (+/- 0,002) erwiesen.

In einer besonders bevorzugten Ausgestaltung des erfindungsgemäßen Quarzglastiegels werden die erste Komponente und die zweite Komponente in Form einer die besagten Komponenten enthaltenden Oxidverbindung in den Dotierungsbereich eingebracht. Ein Kristallisationspromotor in Form einer die erste Komponente und die zweite Komponente enthaltenden Oxidverbindung hat mehrere Vorteile.
- Zum einen sind in einer deratigen Oxidverbindung die Anteile der jeweiligen Komponenten fest vorgegeben, so dass Fehler beim Einwiegen verringert werden.
- Außerdem lassen sich auf diese Weise Zersetzungsprobleme vermeiden, die entstehen können, wenn eine oder jede der Komponenten in einer separaten chemischen Verbindung - etwa in Form eines Carbonates, Nitrates usw. - in den Dotierungsbereich eingebracht wird. Denn bei hohen Temperaturen zersetzt sich beispielsweise Carbonat zu gasförmigem Kohlendioxid oder Nitrat zu nitrosen Gasen, was zu unerwünschter und unkontrollierbarer Gas- und damit Blasenbildung im Tiegel bzw. in der Kristallziehanlage und zu unnötiger Belastung der Umwelt führt.
- Auch im Hinblick auf die Materialkosten erweisen sich Verbindungspartner der ersten oder der zweiten Komponente in jeweils separaten chemischen Verbindungen als überflüssig und werden erfindungsgemäß durch Einsatz einer beide Komponenten enthaltenden Oxidverbindung vermieden.
- Infolge des Fehlens anderer Verbindungspartner der jeweiligen Komponenten in der Oxidverbindung werden ausschließlich die gewünschten Komponenten (Netzwerkbildner und Trennstellenbildner) in den Dotierungsbereich eingebracht, jedoch keine unerwünschten Fremdsubstanzen.

Bevorzugt werden als Oxidverbindung ternäre Oxide wie Bariumtitanat (BaTiO₃) oder Bariumzirkonat (BaZrO₃) oder Gemische hiervon verwendet. Die Kristallisation der Außenschicht wird im Wesentlichen durch den Barium-Anteil dieser oxidischen Verbindungen bewirkt, unterstützt durch den jeweiligen Titanat- bzw. Zirkonat-Anteil. Der Kristallisationspromotor in Form von Bariumtitanat und Bariumzirkonat zeichnet sich durch einen vergleichsweise niedrigen Dampfdruck aus, so dass wenig Fremdsubstanz durch Verdampfen in die Halbleiterschmelze gelangt. Als Beispiel für weitere geeignete ternäre Oxide seien Bariumarsenat oder Bariumaluminat genannt.

Barium und Titan und Zirkonium zeichnen sich durch einen relativ kleinen Verteilungskoeffizienten "k" in Silicium aus. In der Literatur werden für "k" folgende Werte hierfür genannt: für Ba: k < 2.25 · 10⁻⁸, für Ti: k = 1.7 · 10⁻⁶ bzw. k = 2.0 · 10⁻⁶, für Zr: k = 1.7 · 10⁻⁷ bzw. k = 1.7 · 10⁻⁸. Der Titanat- bzw. Zirkonat-Anteil hat noch eine weitere Wirkung, unter der Bedingung, dass diese Bestandteile im Zusammenspiel mit reduzierenden Bedingungen beim Tiegel-Herstellungsprozess zu Suboxiden oder zu den Metallen reduziert werden. Eine derartige Reduzierung kann gelingen, weil sich die Redoxpotenziale von vierwertigem Titan und Zirkonium von demjenigen des vierwertigen Siliciums stark unterscheiden, so dass das vierwertige Titan bzw. Zirkonium leichter zu reduzieren ist als vierwertiges Silicium und sich daher beim Tiegel-Herstellungsprozess in signifikanten Mengen auf die Oxidationsstufe II oder III reduzieren lässt. Die dadurch erreichte reduzierende Wirkung dieser Spezies besteht während des bestimmungsgemäßen Einsatzes des Quarzglastiegels fort und bewirkt dadurch eine Verringerung des Blasenwachstums in der Tiegelwandung. Dieser Effekt ist darauf zurückzuführen, dass die reduzierte Spezies mit den blasenbildenden Gasen (dabei handelt es sich im Wesentlichen um im Quarzglas durch chemische Reaktion freigesetzten Sauerstoff) unter Bildung eines oxidierten Feststoffes reagiert. Insoweit kommt der reduzierten Spezies eine "Getterwirkung" für die überschüssigen, während des Kristallziehprozesses entstehenden Gase (Sauerstoff) zu.

Der Quarzglastiegel weist vorteilhafterweise einen Dotierungsbereich mit einer Schichtdicke von mehr als 1 mm, vorzugsweise von mehr als 2 mm, auf. Kristallisierte Schichten mit Dicken von mehr als 1 mm bzw. von mehr als 2 mm zeichnen sich durch hohe mechanische und thermische Stabilität aus. Ein anderer Vorteil einer dicken kristallisierten Schicht besteht darin, dass beim Abkühlen des erhitzen Tiegels - nach seinem bestimmungsgemäßen Einsatz - durch die diskontinuierliche Änderung des Volumens bei der Phasenumwandlung von β-Cristobalit in α-Cristobalit hohe mechanische Spannungen erzeugt werden, die bewirken, dass der Quarzglastiegel in kleinere Teile zerbricht. Dies erleichtert die Entnahme des Tiegels aus der Kristallziehapparatur.

Vorteilhaft beträgt die Schichtdicke maximal 10 mm. Ein Dotierungsbereich mit einer Schichtdicke von mehr als 10 mm bewirkt eine Kristallisation, die je nach Tiegelgröße zu nahe an die Innenschicht heranreicht und damit die Eigenschaften der Innenschicht (insbesondere deren Reinheit und Blasenfreiheit) ungünstig beeinflussen kann.

Es hat sich bewährt, dass der Quarzglastiegel eine um eine Rotationsachse umlaufende und im Wesentlichen zylinderförmige Seitenwandung aufweist, wobei der Dotierungsbereich als umlaufender Dotierungsstreifen in der Seitenwandung ausgebildet ist. Dadurch kann der kristallisierte Bereich auf das für die Stabilitätserhöhung erforderliche Minimum beschränkt werden. Die Stärke und Breite der während des bestimmungsgemäßen Einsatzes kristallisierenden Schicht ist sehr gut einstellbar, wenn ein Massentransport der Komponenten, die die Kristallisation im Wesentlichen bewirken, weitgehend unterbleibt. Dies ist beispielsweise der Fall bei Barium (Ba²⁺).

Hinsichtlich des Verfahrens wird die oben angegebene technische Aufgabe ausgehend von dem eingangs genannten Verfahren erfindungsgemäß dadurch gelöst, dass als Kristallisationspromotor eine in Quarzglas - zusätzlich zu Silicium - als Netzwerkbildner wirkende und/oder in Quarzglas als Netzwerkwandler wirkende erste Komponente und eine in Quarzglas als Trennstellenbildner wirkende, alkalimetallfreie zweite Komponente eingesetzt wird, und dass die besagten Komponenten in einen eine Schichtdicke von mehr als 0,2 mm aufweisenden Dotierungsbereich der Außenschicht eingebracht und darin eingeschlossen werden.

Erfindungsgemäß wird der Kristallisationspromotor in den Dotierungsbereich in einer Art und Menge eingebracht und darin eingeschlossen, die geeignet ist, bei erneutem Aufheizen des Quarzglastiegels eine Kristallisation im Bereich der Außenoberfläche des Tiegels zu Cristobalit zu bewirken. Die vom Dotierungsbereich ausgehende Kristallisation soll nicht während der Herstellung des Quarzglastiegels erfolgen, sondern erst während dessen bestimmungsgemäßem Einsatz, beispielsweise beim Aufschmelzen des Siliciums zu Beginn des Kristallziehprozesses. Die Kristallisation im Bereich der Außenschicht verbessert die mechanische und thermische Stabilität des Quarzglastiegels und verlängert dessen Standzeit.

Das erfindungsgemäße Verfahren zur Herstellung eines Quarzglastiegels im Sinne der vorliegenden Erfindung unterscheidet sich von dem bekannten Verfahren zur Herstellung eines Quarzglastiegels mit kristallisierter Außenschicht in mehrerer Hinsicht:
- Der Kristallisationspromotor wird in den Dotierungsbereich der Außenschicht eingebracht und darin eingeschlossen. Auf diese Weise lassen sich Konzentration und Verteilung des Kristallisationspromotors eindeutig festlegen. Die Gefahr einer unbeabsichtigten Veränderung der Konzentration und der Verteilung, etwa beim Transport oder beim Einfüllen der Schmelze, besteht nicht, so dass das Verfahren zu reproduzierbaren Ergebnissen führt.
- Ein weiterer wesentlicher Unterschied zu dem bekannten Herstellungsverfahren besteht darin, dass der Kristallisationspromotor mindestens zwei Komponenten umfasst, nämlich eine im Quarzglas als Netzwerkbildner wirkende oder eine in Quarzglas als Netzwerkwandler wirkende erste Komponente und eine im Quarzglas als Trennstellenbildner wirkende, alkalimetallfreie zweite Komponente. Hinsichtlich der Art und der Wirkung der genannten Komponenten wird auf die obigen Erläuterungen zum erfindungsgemäßen Tiegel verwiesen.
   Das Einbringen des Kristallisationspromotors in den Dotierungsbereich der Außenschicht erfolgt in einem frühen Verfahrensstadium, nämlich bei der Herstellung der Außenschicht. Der Dotierungsbereich umfasst die gesamte Außenschicht des Quarzglastiegels oder einen Teil davon; er weist eine Schichtdicke von mindestens 0,2 mm auf, so dass die sich daraus entwickelnde kristallisierte Schicht eine dementsprechende Mindestdicke von mehr als 0,2 mm aufweist, die die Gefahr eines Abplatzens und einer Beschädigung beim Einsatz des Quarzglastiegels vermindert.

Der Kristallisationspromotor kann in den Dotierungsbereich eingebracht werden, indem dieser aus SiO₂-Körnung erzeugt wird, die vorab entsprechend dotiert worden ist. Alternativ dazu kann der Dotierungsbereich nachträglich über die Gasphase oder über eine Flüssigkeit mit der ersten und/oder der zweiten Komponente dotiert werden. In einer bevorzugten Verfahrensweise wird eine den Dotierungsbereich aufweisende Außenschicht erzeugt, indem SiO₂-Körnung in eine Schmelzform eingebracht und darin zu einer tiegelförmigen SiO₂-Körnungsschicht geformt wird, wobei der SiO₂-Körnung vor der Formung des Dotierungsbereichs die besagten Komponenten zudotiert werden, und anschließend die SiO₂-Körnungsschicht unter Bildung der Außenschicht gesintert wird.

Das Einbringen des Kristallisationspromotors (bzw. der ersten und/oder der zweiten Komponente) in die Körnung bzw. in den Dotierungsbereich erfolgt hierbei vor der Formung der Außenschicht im Rahmen der sowieso erforderlichen Körnungsaufbereitung. Es ist somit kein zusätzlicher Verfahrensschritt bei der Tiegelherstellung erforderlich, um die Außenschicht mit dem Kristallisationspromotor zu versehen, wie bei dem eingangs beschriebenen bekannten Verfahren. Zudem erfolgt die Herstellung des Dotierungsbereichs zu Beginn des Schmelzprozesses in einem vergleichsweisen frühen Verfahrensstadium, so dass durch die Dotierung auftretender Ausschuss frühzeitig bemerkt wird, bevor weitere aufwendige Bearbeitungsschritte erfolgt sind.

Die SiO₂-Körnung kann mit den besagten Komponenten ("Netzwerkbildner" und "Trennstellenbildner") dotiert sein; in der bevorzugten Verfahrensvariante werden diese Komponenten der SiO₂-Körnung vor der Formung des Dotierungsbereichs zudotiert, beispielsweise durch Herstellen einer entsprechenden Körnungsmischung.

Vorteilhafte Ausgestaltungen des erfindungsgemäßen Verfahrens ergeben sich aus den weiteren Unteransprüchen. Hinsichtlich der damit verbundenen Vorteile und Wirkungen wird auf die obigen Erläuterungen zum erfindungsgemäßen Quarzglastiegel verwiesen.

Vorzugsweise wird für die als Netzwerkbildner wirkende erste Komponente eine vierwertige Substanz eingesetzt.

Es handelt es sich hierbei um Komponenten, die in den entsprechenden binären oder ternären Oxiden dieselbe Wertigkeit wie Silicium (Si⁴⁺) in der binären Verbindung SiO₂ aufweisen. Hinsichtlich des damit verbundenen Vorteils im Hinblick auf die elektronischen Verhältnisse innerhalb des Quarzglastiegels und innerhalb der im Tiegel enthaltenden Halbleiterschmelze sowie im Einkristall wird auf die obigen Erläuterungen zum erfindungsgemäßen Quarzglastiegel hingewiesen. Vorzugsweise ist die vierwertige Substanz Titan (Ti⁴⁺), Zirkonium (Zr⁴⁺), Hafnium (Hf⁴⁺) Germanium (Ge⁴⁺) und/oder Zinn (Sn⁴⁺), wobei es sich gleichzeitig um "Netzwerkbildner" im klassischen Sinne handelt.

Es hat sich als günstig erwiesen, dass als Trennstellenbildner wirkende zweite Komponente eine zweiwertige, alkalimetallfreie Substanz eingesetzt wird. Derartige "Trennstellenbildner" führen bereits bei geringer Konzentration zu einer Cristobalitbildung, wobei die zur Kristallisation benötigte Konzentration durch den kombinierten Einsatz mit einem oder mehreren "Netzwerkbildnern" im Dotierungsbereich weiter abgesenkt wird.

Vorzugsweise handelt es sich bei der zweiwertigen, alkalimetallfreien Substanz um Barium (Ba²⁺) und/oder Strontium (Sr²⁺). Insbesondere Barium als großes, zweiwertiges Kation zeichnet sich durch eine geringe Beweglichkeit in Quarzglas aus, so dass die kristallisierte Zone leicht auf eine vorgegebene Ausdehnung des Dotierungsbereichs beschränkt werden kann.

Besonders bewährt hat es sich, in den Dotierungsbereich die erste Komponente und die zweite Komponente jeweils in einer Konzentration im Bereich von 0,003 mol-% bis 0,02 mol-% einzubringen. Die genannte Untergrenze des bevorzugten Konzentrationsbereiches ergibt sich durch das Erfordernis einer ausreichenden Kristallisation im Dotierungsbereich beim Einsatz des Tiegels, und die Obergrenze ergibt sich aus der Notwendigkeit, die Gehalte von Fremdsubstanzen im Hinblick auf die erforderliche Reinheit des Halbleitermaterials und stabiler Schmelzbedingungen so gering wie möglich zu halten. Als besonders vorteilhaft haben sich Konzentrationen der ersten und der zweiten Komponente von jeweils etwa 0,006 mol-% (+/- 0,002) erwiesen.

Vorzugsweise werden die erste Komponente und die zweite Komponente in Form einer die besagten Komponenten enthaltenden Oxidverbindung in den Dotierungsbereich der Außenschicht eingebracht. Diese Verfahrensweise hat mehrere Vorteile.
- Zum einen sind in einer Oxidverbindung die Anteile der jeweiligen Komponenten stöchiometrisch bedingt vorgegeben, so dass Fehler beim Einwiegen verringert werden.
- Außerdem lassen sich auf diese Weise Zersetzungsprobleme vermeiden, die entstehen können, wenn eine oder jede der Komponenten in einer separaten chemischen Verbindung - etwa in Form eines Carbonates, Nitrates usw. - in den Dotierungsbereich eingebracht wird. Denn bei hohen Temperaturen zersetzt sich beispielsweise Carbonat zu gasförmigem Kohlendioxid oder Nitrat zu nitrosen Gasen, was zu unerwünschter und unkontrollierbarer Gas- und Blasenbildung im Tiegel und in der Kristallziehapparatur und zu unnötiger Belastung der Umwelt führt.
- Auch im Hinblick auf die Materialkosten erweisen sich die Verbindungspartner der ersten oder der zweiten Komponente in jeweils separaten chemischen Verbindungen als überflüssig und werden erfindungsgemäß durch Einsatz einer beide Komponenten enthaltenden Oxidverbindung vermieden. Infolge des Fehlens anderer Verbindungspartner der jeweiligen Komponenten in der Oxidverbindung werden ausschließlich die gewünschten Komponenten (Netzwerkbildner und Trennstellenbildner) in den Dotierungsbereich eingebracht, jedoch keine unerwünschten Fremdsubstanzen.

Als Oxidverbindung wird in einer besonders bevorzugten Verfahrensweise ein ternäres Oxid, insbesondere in Form von Bariumtitanat (BaTiO₃) oder Bariumzirkonat (BaZrO₃) oder einem Gemisch hiervon eingesetzt. Als Beispiel für weitere geeignete ternäre Oxide seien Bariumarsenat oder Bariumaluminat genannt.

Die Kristallisation der Außenschicht wird im Wesentlichen durch den Barium-Anteil des jeweiligen ternären Oxides bewirkt, unterstützt durch den jeweiligen Titanat- bzw. Zirkonat-Anteil. Die für die Kristallisation benötigte Gesamtmenge an Fremdsubstanz ist gering (auf die obigen Erläuterungen hierzu wird verwiesen).

Kristallisationspromotoren in Form von Bariumtitanat und Bariumzirkonat haben einen vergleichsweise niedrigen Dampfdruck, so dass wenig Fremdsubstanz durch Verdampfen in die Halbleiterschmelze gelangt. Außerdem zeichnen sich Barium und Titan und Zirkonium durch einen relativ kleinen Verteilungskoeffizienten in Silicium aus. Auf die oben zitierten Literaturwerte wird hingewiesen.

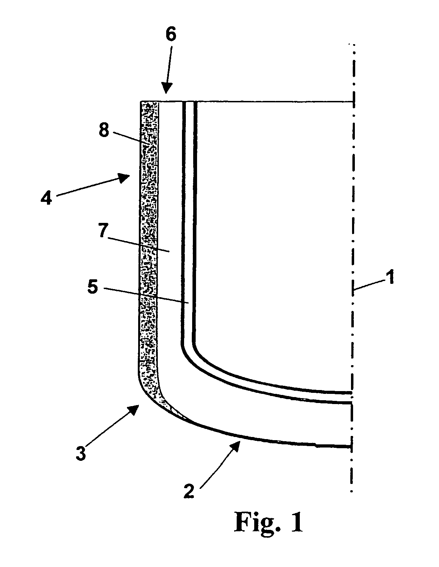

Die Erfindung wird nachfolgend anhand von Ausführungsbeispielen und einer Zeichnung näher erläutert. Als einzige Figur zeigt
- **Figur 1**: die Wandung einer Ausführungsform des erfindungsgemäßen Quarzglastiegels in einem parallel zur Mittelachse verlaufenden Längsschnitt in schematischer Darstellung.

Der Quarzglastiegel nach **Figur 1** ist zur Aufnahme einer Siliciumschmelze zum Ziehen eines Silicium-Einkristalls vorgesehen. Er hat einen Außendurchmesser von 28 Zoll und ist um die Mittelachse 1 rotationssymmetrisch ausgebildet.

Der Quarzglastiegel weist einen leicht gewölbten Boden 2 auf, der über einen Übergangsbereich mit stärkerer Krümmung (im Folgenden als Radius 3 bezeichnet) mit einer im Wesentlichen zylinderförmigen Seitenwand 4 verbunden ist.

Die Innenoberfläche des Quarzglastiegels wird von einer transparenten Innenschicht 5 aus hochreinem, synthetischem Quarzglas gebildet, die je nach Ausbildung im Bereich von Boden 2, Radius 3 und Seitenwand 4 eine unterschiedliche Schichtdicke zwischen 1 und 5 mm aufweist. Die Innenschicht 5 ist mit einer in der Seitenwand im Mittel 15 mm starken Außenschicht 6 aus opakem Quarzglas verbunden.

Die Außenschicht 6 weist einen inneren glasigen Bereich 7 aus reinem, undotiertem, opakem Quarzglas auf, der an eine äußere Schicht angrenzt, die aus opakem, dotiertem Quarzglas besteht, und die im Folgenden als "Außenwandstreifen" oder als "Dotierungsbereich" 8 bezeichnet wird. Die Dotierung im Dotierungsbereich 8 setzt sich zusammen aus einer in Quarzglas als Netzwerkbildner wirkenden Komponente und einer in Quarzglas als Trennstellenbildner wirkenden Komponente. Der Dotierungsbereich 8 bildet die Außenoberfläche des Tiegels, wobei er sich mit einer Schichtdicke von 4 mm über die gesamte Seitenwand 4 erstreckt und im Radius 3 dünn ausläuft.

Im folgenden wird die Herstellung des erfindungsgemäßen Quarzglastiegels zunächst in allgemeiner Form, und anschließend anhand von konkreten Ausführungsbeispielen näher beschrieben.

In einem ersten Verfahrensschritt wird kristalline Körnung aus natürlichem, mittels Heißchlorierung gereinigtem Quarz mit einer bevorzugten Korngröße im Bereich von 90 µm bis 315 µm in eine Metallform eingefüllt, die um ihre Längsachse rotiert. Unter der Wirkung der Zentrifugalkraft und mittels einer Schablone wird an der Innenwandung der Metallform eine rotationssymmetrische tiegelförmige Quarzkörnungs-Schicht geformt.

In einem zweiten Verfahrensschritt wird auf der Innenwandung der Quarzkörnungs-Schicht mittels des sogenannten "Lichtbogenschmelzens" eine transparente Innenschicht erzeugt. Hierzu wird unter anhaltender Rotation der Metallform hochreine synthetische Quarzkörnung durch einen Lichtbogen, der von oben in die Metallform abgesenkt wird, eingestreut. Die durch den Lichtbogen eingestreute Körnung wird erweicht und gegen die Innenwandung der Quarzkörnungs-Schicht geschleudert und darauf aufgeschmolzen. An der Innenwandung wird eine Maximaltemperatur von über 2100°C erreicht. Es bildet sich eine nach außen, in Richtung auf die Metallform, fortschreitende Schmelzfront, in deren Folge die Innenschicht zu einem transparentem Quarzglas erschmolzen und die Quarzkörnungs-Schicht zu einer Außenschicht aus opakem Quarzglas gesintert wird. Das Erschmelzen wird beendet, bevor die Schmelzfront die Metallform erreicht. Die innere Oberfläche des Quarzglastiegels wird somit von einer glatten, glasigen, blasenfreien, hochreinen Innenschicht aus synthetisch erzeugtem SiO₂ gebildet, die mit der Außenschicht fest verbunden ist.

Aufgrund der hohen Reinheit der synthetischen Innenschicht ist die Kristallisationsneigung der Innenschicht gering, so dass eine mit der Cristobalitbildung auf der Oberfläche der Innenschicht einhergehende Emission von Kristallpartikeln in die Halbleiterschmelze vermieden und dadurch die Standzeit des Tiegels verbessert wird.

Der Lichtbogen wird unter Atmosphärenbedingungen (an Luft) durch drei Graphitelektroden gezündet. Durch Abbrand von Graphit bilden sich CO₂ und CO, wobei aufgrund der hohen Temperaturen von mehreren tausend Grad Celsius das Boudouard-Gleichgewicht deutlich zu Gunsten der CO-Bildung verschoben ist, so dass sich eine insgesamt reduzierende wirkende Schmelzatmosphäre einstellt.

Eine Besonderheit der Erfindung besteht darin, dass bei der Herstellung der Außenschicht ein Kristallisationspromotor umfassend mindestens eine weitere (zusätzlich zu SiO₂) als Netzwerkbildner wirkende Komponente und mindestens eine als Trennstellenbildner wirkende Komponente in einen Dotierungsbereich eingebracht und darin eingeschlossen wird.

Die Herstellung der Außenschicht und das Einbringen des Kristallisationspromotors in den Dotierungsbereich wird nachfolgend anhand von Ausführungsbeispielen näher erläutert:

### Beispiel 1

Es wird eine Mischung von Quarzkörnung (Quarzsand) mit käuflich erhältlichem Bariumtitanat-Pulver durch Mischen in einem Rhönradmischer hergestellt. In der Mischung sind 0,002 mol Bariumtitanat pro kg Quarzkörnung enthalten, die eingewogene Menge beträgt 466 mg BaTiO₃ / kg Quarzkörnung.

Beim Formen der Quarzkörnungs-Schicht wird aus der Mischung ein um die Rotationsachse umlaufender dotierter Außenwandstreifen gebildet, der an der Außenwandung der Quarzkörnungs-Schicht endet und der im fertigen Tiegel eine Schichtdicke von 3 mm aufweist. Der mit Bariumtitanat dotierte Außenwandstreifen wird so geformt, dass er sich im fertigen Tiegel vom oberen Tiegelrand 5 cm nach unten erstreckt.

Nach dem Aufbringen der Innenschicht auf der Innenwandung der Quarzkörnungs-Schicht und Sintern der Tiegelwandung mittels Lichtbogenschmelzen wird der erfindungsgemäße Quarzglastiegel erhalten. Der Außenwandstreifen hat nach dem Sintern eine Stärke von ca. 3 mm. Eine Kristallisation - insbesondere im Bereich des Außenwandstreifens - ist mit bloßem Auge nicht erkennbar.

### Beispiel 2

Es wird eine Mischung von Quarzkörnung mit Bariumtitanat-Pulver durch Mischen in einem Rhönradmischer hergestellt. In der Mischung sind 0,001 mol Bariumtitanat / kg Quarzkörnung enthalten; die eingewogene Menge beträgt 233 mg BaTiO₃ pro kg Quarzkörnung.

Beim Formen der Quarzkörnungs-Schicht wird aus der Mischung ein um die Rotationsachse umlaufender dotierter Außenwandstreifen gebildet. Der Außenwandstreifen verläuft an der Außenwandung der Quarzkörnungs-Schicht und er erstreckt sich im fertigen Tiegel vom oberen Tiegelrand 10 cm nach unten.

Nach dem Aufbringen der Innenschicht auf der Innenwandung der Quarzkörnungs-Schicht und Sintern der Tiegelwandung (inkl. Erschmelzen der Quarzkörnungs-Schicht) mittels Lichtbogenschmelzen wird der erfindungsgemäße Quarzglastiegel erhalten. Der Außenwandstreifen hat nach dem Sintern eine Stärke von ca. 4 mm. Eine Kristallisation - insbesondere im Bereich des Außenwandstreifens - ist mit bloßem Auge nicht erkennbar.

### Beispiel 3

Es wird eine Mischung von Quarzkörnung mit Bariumtitanat-Pulver durch Mischen in einem Rhönradmischer hergestellt. In der Mischung sind 0,001 mol Bariumtitanat / pro kg der Quarzkörnung enthalten; die eingewogene Menge beträgt 233 mg BaTiO₃ / kg Quarzkörnung.

Die Mischung wird eingesetzt, um beim Formen der Quarzkörnungs-Schicht einen an der Außenoberfläche endenden Dotierungsbereich zu erzeugen, der sich über die gesamten Seitenwand des Quarzglastiegels (ohne den Bodenbereich) erstreckt.

Nach dem Aufbringen der synthetischen Innenschicht auf der Innenwandung der Quarzkörnungs-Schicht und Sintern der Tiegelwandung mittels Lichtbogenschmelzen wird der erfindungsgemäße Quarzglastiegel gemäß Figur 1 erhalten. Der Bariumtitanat enthaltende Dotierungsbereich hat nach dem Sintern eine Stärke von ca. 3 mm. Eine Kristallisation - insbesondere im Dotierungsbereich- ist mit bloßem Auge nicht erkennbar.

### Beispiel 4

Es wird eine Mischung von Quarzkörnung der Korngröße im Bereich von 90 µm bis 315 µm mit käuflich erhältlichem Bariumzirkonat-Pulver durch Mischen in einem Rhönradmischer hergestellt. In der Mischung sind 0,002 mol Bariumzirkonat pro kg der Quarzkörnung enthalten; die eingewogene Menge beträgt 552 mg BaZrO₃ / kg Quarzkörnung.

Die Mischung wird eingesetzt, um beim Formen der Quarzkörnungs-Schicht einen an der Außenoberfläche endenden Dotierungsbereich zu erzeugen, der sich über die gesamten Seitenwand des Quarzglastiegels (ohne den Bodenbereich) erstreckt.

Nach dem Aufbringen der Innenschicht auf der Innenwandung der Quarzkörnungs-Schicht und Sintern der Tiegelwandung mittels Lichtbogenschmelzen wird der erfindungsgemäße Quarzglastiegel erhalten. Der Dotierungsbereich hat nach dem Sintern eine Stärke von ca. 5 mm. Eine Kristallisation ist mit bloßem Auge nicht erkennbar.

### Beispiel 5

Es wird eine Mischung von Quarzkörnung mit Bariumzirkonat-Pulver durch Mischen in einem Rhönradmischer hergestellt. In der Mischung sind 0,001 mol Bariumzirkonat pro kg Quarzkörnung (eingewogene Menge: 276 mg pro kg an Quarzkörnung) enthalten.

Die Mischung wird eingesetzt, um beim Formen der Quarzkörnungs-Schicht einen an der Außenoberfläche endenden Dotierungsbereich zu erzeugen, der sich über die gesamte Seitenwand erstreckt (ohne den Bodenbereich).

Nach dem Aufbringen der synthetischen Innenschicht auf der Innenwandung der Quarzkörnungs-Schicht und Sintern der Tiegelwandung mittels Lichtbogenschmelzen wird der erfindungsgemäße Quarzglastiegel gemäß Figur 1 erhalten. Der Bariumzirkonat enthaltende Dotierungsbereich hat im fertigen Tiegel (nach dem Sintern) eine Schichtdicke von etwa 6 mm. Eine Kristallbildung - insbesondere im Dotierungsbereich - ist mit bloßem Auge nicht erkennbar.

Die nach den Beispielen 1 bis 5 hergestellten Tiegel werden zerschlagen und es werden Scherben für einen "Kristallisationstest", einen "Vacuum Bake Test" und einen "24-Stunden Vacuum Bake Test" präpariert.

### Kristallisationstest

Während des Kristallisationstests wird die Aufschmelzphase in der Kristallzucht simuliert. Das gefahrene Temperaturprogramm entspricht etwa der Temperatur im Radius eines 28"-Tiegels während der Aufschmelzphase. Dadurch soll sichergestellt werden, dass bis zum Beginn der Kristallzucht eine ausreichend dicke kristalline Schicht entstanden ist. Anschließend werden die Scherben graphisch ausgewertet. Die Proben werden dazu photographiert und es werden die Schichtdicken vermessen.

### Vacuum Bake Test

Beim Vacuum Bake Test werden die Temperatur- und Druckbedingungen während der Standard-Kristallzucht simuliert, um das Blasenwachstum in der Innenschicht der Tiegel zu beurteilen. Dazu werden Proben aus Boden, Radius und Seitenwand des Tiegels vier Stunden bei 1600°C und 10 mbar gehalten. Anschließend werden Dünnschnitte der Scherben geschnitten und die Blasenbilder der Innenschichten der Proben aufgenommen.

### 24 Stunden Vacuum Bake Test

Der 24h-Vacuum Bake Test wird zur Simulation des Blasenwachstums insbesondere der Innenschicht bei besonders langer Prozessdauer eingesetzt, wie sie beim Einsatz von 28"-Tiegeln realistisch ist. Dazu werden die Proben 24 Stunden bei 1600°C und 10 mbar gehalten. Anschließend wird das Blasenwachstum anhand der Dünnschnitte betrachtet. Der 24h-Vacuum Bake Test zeigt auch das endgültige Kristallisationsverhalten des Tiegels. Nach 24h ist die Kristallisation nahezu beendet, so dass anhand dieses Testes festgestellt werden kann, ob die Kristallisation z.B. in Bereiche wandert, die nicht kristallisieren sollten. Dazu werden Proben aus Boden, Radius , Seitenwand (unten, mittig und oben) untersucht, so dass ein Gesamikristallisationsbild des Tiegels erstellt werden kann.

### Ergebnisse

Proben aus den gemäß Beispiel 1 bis 5 hergestellten Quarzglastiegeln wurden den genannten Testverfahren unterzogen. Die Ergebnisse sind in Tabelle 1 dargestellt.

**Tabelle 1**

| **Probe** | **Kristallisationstest Schichtdicke [mm]** | **Vacuum Bake Test** **Blasenbildung** | **24h-Vacuum Bake Test** | |
|---|---|---|---|---|
| | | | **Blasenbildung** | **Kristallisation** |
| 1 | 3 | Blasenwachstum vergleichbar oder besser als in Quarzglastiegeln ohne Außenwanddotierung | vergleichbar oder besser als in Quarzglastiegeln ohne Außenwanddotierung | Streifen vollständig kristallisiert |
| 2 | 4 | | | |
| 3 | 3 | | | Dotierungsbereich vollständig kristallisiert |
| 4 | 5 | | | |
| 5 | 6 | | | |

Der gemäß Beispiel 1 hergestellte Quarzglastiegel (Probe 1) zeigte ein Kristallisationswachstum in einem ca. 5 cm schmalen Streifen im oberen Wandbereich. Es zeigte sich, dass die kristallisierte Schicht bis in die Nähe der Innenschicht reicht.

Der nach Beispiel 2 hergestellte Quarzglastiegel (Probe 2) zeigte aufgrund der geringeren Konzentration an Kristallisationspromotor eine leicht verringerte, jedoch noch vollständig ausreichende Kristallisation im Bereich der oberen Außenwand des Quarzglastiegels.

Beim Erzeugen des dotierten Außenwandstreifens gemäß den Beispielen 1 und 2 ist auf eine definierte örtliche Verteilung des Kristallisationspromotors zu achten, da die dotierte Schicht in keinem Fall bis an die Innenschicht heranreichen darf.

Bei dem nach Beispiel 3 hergestellten Quarzglastiegel (Probe 3) ist die gesamte Außenwand mit dem Kristallisationspromotor (Bariumtitanat) dotiert. Der dotierte Bereich erstreckt sich an der Außenoberfläche von dem oberen Rand des Quarzglastiegels bis hinab in den Radius zwischen Boden und Wandung. Das Verfahren führte zu einer vollständigen Kristallisation des Dotierungsbereiches der Außenwandung beim Kristallisationstest. Die kristallisierte Schicht ist gleichmäßig dick und läuft im Radius zum Boden hin dünn aus. Der Verlauf der kristallisierten Schicht entspricht exakt dem gewünschten Verlauf. Die kristallisierte Schicht kommt in keinem Bereich in die Nähe der Innenschicht.

Bei dem nach Beispiel 4 hergestellten Quarzglastiegel (Probe 4) wurde eine vergleichbare Kristallisation im Tiegel beobachtet wie bei dem nach dem Beispiel 3 hergestellten Tiegel.

Der nach Beispiel 5 hergestellte Quarzglastiegel (Probe 5) zeigte das gleiche Kristallisations-Ergebnis wie der nach Beispiel 3 und 4 hergestellte Tiegel. Die Dicke der Kristallisationsschicht beträgt 6 mm. Die energetischen Verhältnisse bei der Dotierung mit BaZrO₃ führen jedoch dazu, dass der Tiegel im Gegensatz zur Dotierung mit BaTiO₃ mit wesentlich geringeren Prozessanpassungen geschmolzen werden kann.

## Patentansprüche

1. Quarzglastiegel zum Kristallziehen mit einer Tiegelwandung, umfassend eine Außenschicht aus opakem Quarzglas und eine Innenschicht, wobei die Außenschicht einen inneren Bereich und einen äußeren Bereich aufweist, der mit einem Kristallisationspromotor versehen ist, der beim Aufheizen des Quarzglastiegels beim bestimmungsgemäßen Einsatz beim Kristallziehen eine Kristallisation von Quarzglas unter Bildung von Cristobalit bewirkt, **dadurch gekennzeichnet, dass** der Kristallisationspromotor eine in Quarzglas - zusätzlich zu Silicium - als Netzwerkbildner wirkende und/oder eine in Quarzglas als Netzwerkwandler wirkende erste Komponente und eine in Quarzglas als Trennstellenbildner wirkende, alkalimetallfreie zweite Komponente enthält, und dass die besagten Komponenten in einem eine Schichtdicke von mehr als 0,2 mm aufweisenden Dotierungsbereich (8) der Außenschicht (6) enthalten und darin eingeschlossen sind.

2. Quarzglastiegel nach Anspruch 1, **dadurch gekennzeichnet, dass** die als Netzwerkbildner wirkende erste Komponente eine vierwertige Substanz enthält.

3. Quarzglastiegel nach Anspruch 2, **dadurch gekennzeichnet, dass** die vierwertige Substanz Titan (Ti⁴⁺), Zirkonium (Zr⁴⁺), Hafnium (Hf⁴⁺) Germanium (Ge⁴⁺) und/oder Zinn (Sn⁴⁺) ist.

4. Quarzglastiegel nach Anspruch 1, **dadurch gekennzeichnet, dass** die als Trennstellenbildner wirkende zweite Komponente eine zweiwertige, alkalimetallfreie Substanz enthält.

5. Quarzglastiegel nach Anspruch 4, **dadurch gekennzeichnet, dass** die zweiwertige, alkalimetallfreie Substanz Barium (Ba²⁺) und/oder Strontium ist.

6. Quarzglastiegel nach einem der Ansprüche 1 bis 5, **dadurch gekennzeichnet, dass** die erste und die zweite Komponente einen Verteilungskoeffizienten in Silicium von maximal 10⁻⁵ aufweisen.

7. Quarzglastiegel nach einem der Ansprüche 1 bis 6, **dadurch gekennzeichnet, dass** die erste Komponente und die zweite Komponente jeweils in einer Konzentration im Bereich von 0,003 mol-% bis 0,02 mol-% im Dotierungsbereich enthalten sind.

8. Quarzglastiegel nach einem der Ansprüche 1 bis 7, **dadurch gekennzeichnet, dass** die erste Komponente und die zweite Komponente in Form einer die besagten Komponenten enthaltenden Oxidverbindung im Dotierungsbereich (8) enthalten sind.

9. Quarzglastiegel nach Anspruch 8, **dadurch gekennzeichnet, dass** die Oxidverbindung aus einem ternären Oxid, wie Bariumtitanat (BaTiO₃) oder Bariumzirkonat (BaZrO₃) oder einem Gemisch hiervon besteht.

10. Quarzglastiegel nach einem der Ansprüche 1 bis 9, **dadurch gekennzeichnet, dass** der Dotierungsbereich (8) eine Schichtdicke von mehr als 0,5 mm, vorzugsweise von mehr als 2 mm aufweist.

11. Quarzglastiegel nach Anspruch 10, **dadurch gekennzeichnet, dass** die Schichtdicke maximal 10 mm beträgt.

12. Quarzglastiegel nach einem der Ansprüche 1 bis 11, **dadurch gekennzeichnet, dass** der Quarzglastiegel eine um eine Rotationsachse (1) umlaufende und im Wesentlichen zylinderförmige Seitenwandung (4) aufweist, wobei der Dotierungsbereich (8) als umlaufender Dotierungsstreifen in der Seitenwandung (4) ausgebildet ist.

13. Verfahren zur Herstellung eines Quarzglastiegels nach einem der Ansprüche 1 bis 12, indem ein eine Außenschicht aus opakem Quarzglas und eine Innenschicht aufweisender Tiegelbasiskörper hergestellt wird, wobei die Außenschicht in einem, einen inneren Bereich umgebenden äußeren Bereich mindestens teilweise mit einem Kristallisationspromotor versehen wird, der beim Aufheizen des Quarzglastiegels beim bestimmungsgemäßen Einsatz beim Kristallziehen eine Kristallisation von Quarzglas unter Bildung von Cristobalit bewirkt, **dadurch gekennzeichnet, dass** als Kristallisationspromotor eine in Quarzglas - zusätzlich zu Silicium - als Netzwerkbildner wirkende und/oder eine in Quarzglas als Netzwerkwandler wirkende erste Komponente und eine in Quarzglas als Trennstellenbildner wirkende, alkalimetallfreie zweite Komponente eingesetzt wird, und dass die besagten Komponenten in einen eine Schichtdicke von mehr als 0,2 mm aufweisenden Dotierungsbereich (8) der Außenschicht (6) eingebracht und darin eingeschlossen werden.

14. Verfahren nach Anspruch 13, **dadurch gekennzeichnet, dass** eine den Dotierungsbereich (8) aufweisende Außenschicht (6) erzeugt wird, indem SiO₂-Körnung in eine Schmelzform eingebracht und darin zu einer tiegelförmigen SiO₂-Körnungsschicht geformt wird, wobei der SiO₂-Körnung vor der Formung des Dotierungsbereichs (8) die besagten Komponenten zudotiert werden, und anschließend die SiO₂-Körnungsschicht unter Bildung der Außenschicht (6) gesintert wird.

15. Verfahren nach Anspruch 13 oder 14, **dadurch gekennzeichnet, dass** als Netzwerkbildner wirkende erste Komponente eine vierwertige Substanzen eingesetzt wird.

16. Verfahren nach Anspruch 15, **dadurch gekennzeichnet, dass** als vierwertige Substanz Titan (Ti⁴⁺), Zirkonium (Zr⁴⁺), Hafnium (Hf⁴⁺) Germanium (Ge⁴⁺) und/oder Zinn (Sn⁴⁺) eingesetzt wird

17. Verfahren nach einem der Ansprüche 13 bis 16, **dadurch gekennzeichnet, dass** als Trennstellenbildner wirkende zweite Komponente eine zweiwertige, alkalimetallfreie Substanz eingesetzt wird.

18. Verfahren nach Anspruch 17, **dadurch gekennzeichnet, dass** die zweiwertige Substanz Barium (Ba²⁺) und/oder Strontium ist

19. Verfahren nach einem der Ansprüche 13 bis 18, **dadurch gekennzeichnet, dass** in den Dotierungsbereich die erste Komponente und die zweite Komponente jeweils in einer Konzentration im Bereich von 0,003 mol-% bis 0,02 mol-% eingebracht werden.

20. Verfahren nach einem der Ansprüche 13 bis 19, **dadurch gekennzeichnet, dass** die erste Komponente und die zweite Komponente in Form einer die besagten Komponenten enthaltenden Oxidverbindung in den Dotierungsbereich (8) der Außenschicht (6) eingebracht werden.

21. Verfahren nach Anspruch 20, **dadurch gekennzeichnet, dass** als Oxidverbindung ein ternäres Oxid, insbesondere Bariumtitanat (BaTiO₃) oder Bariumzirkonat (BaZrO₃) oder einGemisch hiervon eingesetzt wird.

## Claims

1. Quartz glass crucible for crystal pulling with a crucible wall, comprising an outer layer of opaque quartz glass and an inner layer, wherein the outer layer has an inner region and an outer region, which is provided with a crystallization promoter that effects crystallization of quartz glass with formation of cristobalite when the quartz glass crucible is heated during intended use in crystal pulling, **characterized in that** the crystallization promoter contains a first component acting in quartz glass - additionally to silicon - as a network former and/or a network modifier in quartz glass and a second, alkali-metal-free component acting in quartz glass as a breakpoint former, and that the outer layer (6) comprises a doping region (8) having a layer thickness of more than 0.2 mm containing said components being entrapped therein.

2. Quartz glass crucible according to claim 1, **characterized in that** the first component acting as network former contains a tetravalent substance.

3. Quartz glass crucible according to claim 2, **characterized in that** the tetravalent substance is titanium (Ti⁴⁺), zirconium (Zr⁴⁺), hafnium (Hf⁴⁺), germanium (Ge⁴⁺) and/or tin (Sn⁴⁺).

4. Quartz glass crucible according to claim 1, **characterized in that** the second component acting as breakpoint former contains a divalent alkali-free-metal substance.

5. Quartz glass crucible according to claim 4, **characterized in that** the divalent, alkali-metal-free substance is barium (Ba²⁺) and/or strontium.

6. Quartz glass crucible according to one of claims 1 to 5, **characterized in that** the first and the second component have a distribution coefficient in silicon of 10⁻⁵ max.

7. Quartz glass crucible according to one of claims 1 to 6, **characterized in that** the first component and the second component are each contained in a concentration ranging from 0.003 mol-% to 0.02 mol-% in the doping region.

8. Quartz glass crucible according to one of claims 1 to 7, **characterized in that** the first component and the second component are contained in the doping region (8) in the form of an oxide compound containing the said components.

9. Quartz glass crucible according to claim 8, **characterized in that** the oxide compound consists of a ternary oxide, such as barium titanate (BaTiO₃) or barium zirconate (BaZrO₃) or a mixture thereof.

10. Quartz glass crucible according to one of claims 1 to 9, **characterized in that** the doping region (8) has a layer thickness of more than 0.5 mm, preferably more than 2 mm.

11. Quartz glass crucible according to claim 10, **characterized in that** the layer thickness is 10 mm max.

12. Quartz glass crucible according to one of claims 1 to 11, **characterized in that** the quartz glass crucible has an essentially cylindrical side wall (4) about the axis of rotation (1), wherein the doping region (8) is formed as a doping strip in the side wall (4).

13. Method for manufacturing a quartz glass crucible according to one of claims 1 to 12 by producing a crucible base body comprising an outer layer of opaque quartz glass and an inner layer, wherein at least part of the outer layer in an outer region surrounding an inner region is provided with a crystallization promoter which, on heating of the quartz glass crucible during intended use in crystal pulling, causes crystallization of quartz glass with formation of cristobalite, **characterized in that** a first component acting in quartz glass - additionally to silicon - as network former and/or in quartz glass as network modifier, and an alkali-metal-free second component acting as breakpoint former in quartz glass is used as crystallization promoter, and that said components are introduced into and entrapped in a doping region (8) of the outer layer (6) having a layer thickness of more than 0.2 mm.

14. Method according to claim 13, **characterized in that** an outer layer (6) having the doping region (8) is generated **in that** SiO₂ grains are introduced into a melting mold and shaped therein into a crucible-shaped layer of SiO₂ grains, wherein said components are added to the SiO₂ grains before shaping of the doping region (8), and then the layer of SiO₂ grains is sintered with formation of the outer layer (G).

15. Method according to one of claims 13 or 14, **characterized in that** a tetravalent substance is used as the network-forming first component.

16. Method according to claim 15, **characterized in that** the tetravalent substance is titanium (Ti⁴⁺), zirconium (Zr⁴⁺), hafnium (Hf⁴⁺), germanium (Ge⁴⁺) and/or tin (Sn⁴⁺).

17. Method according to one of claims 13 to 16, **characterized in that** the second component acting as breakpoint former contains a divalent alkali-free-metal substance.

18. Method according to claim 17, **characterized in that** the divalent substance is barium (Ba²⁺) and/or strontium.

19. Method according to one of claims 13 to 18, **characterized in that** the first component and the second component are each introduced in a concentration ranging from 0.003 mol-% to 0.02 mol-% in the doping region.

20. Method according to one of claims 13 to 19, **characterized in that** the first component and the second component are contained in the doping region (8) of the outer layer (6) in the form of an oxide compound containing said components.

21. Method according to claim 20, **characterized in that** the oxide compound consists of a ternary oxide, such as barium titanate (BaTiO₃) or barium zirconate (BaZrO₃) or a mixture thereof.

## Revendications

1. Creuset en verre de quartz pour le tirage de cristaux avec une paroi de creuset comprenant une couche externe en verre de quart opaque et une couche interne, la couche externe présentant une zone interne et une zone externe, qui est munie d'un promoteur de cristallisation qui, lors du chauffage du creuset en verre de quartz pour l'emploi conforme à la détermination et l'étirage de cristaux, provoque une cristallisation de verre de quartz dans la formation de cristobalite, **caractérisé en ce que** le promoteur de cristallisation contient un premier composant agissant - en plus du silicium - en tant que formateur de réseau et/ou un premier composant agissant dans le verre de quartz comme transformateur de réseau et un second composant exempt de métaux alcalins agissant dans le verre de quartz comme formateur de points de rupture et **en ce que** lesdits composants sont contenus et enrobés dans une zone de dopage (8) de la couche externe (6), présentant une épaisseur supérieure à 0,2 mm.

2. Creuset en verre de quartz selon la revendication 1, **caractérisé en ce que** le premier composant agissant comme formateur de réseau contient une substance tétravalente.

3. Creuset en verre de quartz selon la revendication 2, **caractérisé en ce que** la substance tétravalente est du titane (Ti⁴⁺), du zirconium (Zr⁴⁺), de l'hafnium (Hf⁴⁺), du germanium (Ge⁴⁺) et/ou de l'étain (Sn⁴⁺).

4. Creuset en verre de quartz selon la revendication 1, **caractérisé en ce que** le second composant agissant comme un formateur de point de rupture contient une substance bivalente exempte de métaux alcalins.

5. Creuset en verre de quartz selon la revendication 4, **caractérisé en ce que** la seconde substance bivalente sans métaux alcalins et du baryum (Ba²⁺) et/ou du strontium.

6. Creuset en verre de quartz selon l'une des revendications 1 à 5, **caractérisé en ce que** le premier et le second composants présentent un coefficient de répartition en silicium de 10⁻⁵ maximum.

7. Creuset en verre de quartz selon l'une des revendications 1 à 6, **caractérisé en ce que** le premier composant et le second composant sont contenus respectivement dans une concentration comprise entre 0,0003 % mol et 0,02 % mol dans la zone de dopage.

8. Creuset en verre de quartz selon l'une des revendications 1 à 7, **caractérisé en ce que** le premier composant et le second composant sont contenus sous forme d'une liaison d'oxyde contenant lesdits composants dans la zone de dopage (8).

9. Creuset en verre de quartz selon la revendication 8, **caractérisé en ce que** le composé d'oxyde se compose d'un oxyde ternaire, tel que le titanate de baryum (BaTiO₃) ou un zirconate de baryum (BaZrO₃) ou un mélange de ces derniers.

10. Creuset en verre de quartz selon l'une des revendications 1 à 9, **caractérisé en ce que** la zone de dopage (8) présente une épaisseur de couche supérieure à 0,5 mm de préférence supérieure à 2 mm.

11. Creuset en verre de quartz selon la revendication 10, **caractérisé en ce que** l'épaisseur maximale de couche est de 10 mm.

12. Creuset en verre de quartz selon l'une des revendications 1 à 11, **caractérisé en ce que** le creuset en verre de quartz présente une paroi latérale essentiellement cylindrique (4) et tournant autour d'un axe de rotation (1), la zone de dopage (8) étant réalisée comme bande de dopage circulaire dans la paroi latérale (4).

13. Procédé de fabrication d'un creuset en verre de quartz selon l'une des revendications 1 à 12, selon lequel un corps de base de creuset présentant une couche externe en verre de quartz opaque et une couche interne est fabriqué, la couche interne étant munie dans une zone externe entourant une zone interne au moins partiellement d'un promoteur de cristallisation qui, lors du chauffage du creuset en verre de quartz pour l'emploi conforme au but et l'étirage de cristaux, provoque une cristallisation de verre de quartz dans la formation de cristobalite, **caractérisé en ce que** le promoteur de cristallisation contient un premier composant agissant - en plus du silicium - en tant que formateur de réseau et/ou un premier composant agissant dans le verre de quartz comme transformateur de réseau et un second composant exempt de métaux alcalins agissant dans le verre de quartz comme formateur de points de rupture et **en ce que** lesdits composants sont contenus et enrobés dans une zone de dopage (8) de la couche externe (6), présentant une épaisseur supérieure à 0,2 mm.

14. Procédé selon la revendication 13, **caractérisé en ce qu'**il est généré une couche externe (6) présentant la zone de dopage (8) dans le fait que le granulé de SiO₂ est amené dans un moule de fusion et y est moulé en une couche de granulé siO₂ en forme de creuset, le granulé de SiO₂ étant dopé auxdits composants avant la formation de la zone de dopage (8), et ensuite la couche de granulé SiO₂ étant frittée en formant la couche externe (6).

15. Procédé selon la revendication 13 ou 14, **caractérisé en ce que** le premier composant agissant comme formateur de réseau contient une substance tétravalente.

16. Procédés selon la revendication 15, **caractérisé en ce qu'**il est utilisé en tant que substance tétravalente, du titane (Ti⁴⁺), du zirconium (Zr⁴⁺), de l'hafnium (Hf⁴⁺), du germanium (Ge⁴⁺) et/ou de l'étain (Sn⁴⁺).

17. Procédé selon l'une des revendications 13 à 16, **caractérisé en ce qu'**il est utilisé en tant que second composant agissant comme un formateur de point de rupture une substance bivalente exempte de métaux alcalins.

18. Procédé selon la revendication 17, **caractérisé en ce que** la seconde substance bivalente sans métaux alcalins est du baryum (Ba²⁺) et/ou du strontium.

19. Procédé selon l'une des revendications 13 à 18, **caractérisé en ce que** le premier composant et le second composant sont contenus respectivement dans une concentration comprise entre 0,0003 % mol et 0,02 % mol dans la zone de dopage.

20. Procédé selon l'une des revendications 13 à 19, **caractérisé en ce que** le premier composant et le second composant sont intégrés sous forme d'une liaison d'oxyde contenant lesdits composants dans la zone de dopage (8) de la couche externe (6).

21. Procédé selon la revendication 20, **caractérisé en ce qu'**il est utilisé en tant que composé d'oxyde un oxyde ternaire, en particulier le titanate de baryum (BaTi03) ou le zirconate de baryum (BaZrO₃) ou un mélange de ces derniers.
